# EUROPEAN PATENT SPECIFICATION

(11) **EP 3 879 931 B1**
(45) Date of publication and mention of the grant of the patent: **07.05.2025**
(21) Application number: 21162097.6
(22) Date of filing: 11.03.2021
(51) Int. Cl.: H05B 6/12, H05B 6/06

(54) **ELECTRIC RANGE**
ELEKTRISCHE HERDPLATTE
CUISINIÈRE ÉLECTRIQUE

(30) Priority: 12.03.2020 KR 20200030919
(43) Date of publication of application: 15.09.2021
(73) Proprietor: LG Electronics Inc., Seoul 07336 (KR)
(72) Inventor: PARK, Jinwoo, 06772 Seoul (KR); CHA, Jungmin, 06772 Seoul (KR); Jaeho, LEE, 06772 Seoul (KR); PARK, Il Young, 06772 Seoul (KR); KIM, Seunghak, 06772 Seoul (KR)
(74) Representative: Ter Meer Steinmeister & Partner

(56) References cited:
- WO-A1-2018/199613
- DE-A1- 102006 030 547
- JP-A- 2007 294 474
- KR-A- 20180 072 628
- US-A1- 2020 053 838

## Description

### FIELD

Disclosed herein is an electric range that can ensure optimization of electromagnetic compatibility.

### BACKGROUND

Various types of cooking appliances are used to heat food at homes or restaurants. The cooking appliances include gas ranges using gas and electric ranges using electricity.

The electric ranges are classified as resistance heating-type electric ranges and induction heating-type electric ranges.

In a resistance heating method, electric current is supplied to a metallic resistance wire or a non-metallic heat generation element such as silicon carbide to generate heat, and the generated heat is radiated or conducted to heat an object to be heated (e.g., a cooking vessel such as a pot, a frying pan and the like).

In an induction heating method, high-frequency power is supplied to a coil to generate a magnetic field around the coil, and eddy current produced in the generated magnetic field is used to heat an object to be heated made of a metallic material.

Regarding basic theories of induction heating, when electric current is supplied to a working coil, heat is generated while an object to be heated is inductively heated, and the object to be heated is heated by the generated heat.

A magnetic field generated as a result of driving of the working coil affects other electronic devices. For example, the screen of a TV in the living room can flicker due to a magnetic field of an induction heating device in the kitchen.

To solve the problem, the induction heating device is provided with a filter circuit. The filter circuit can reduce noise that affects another electronic device.

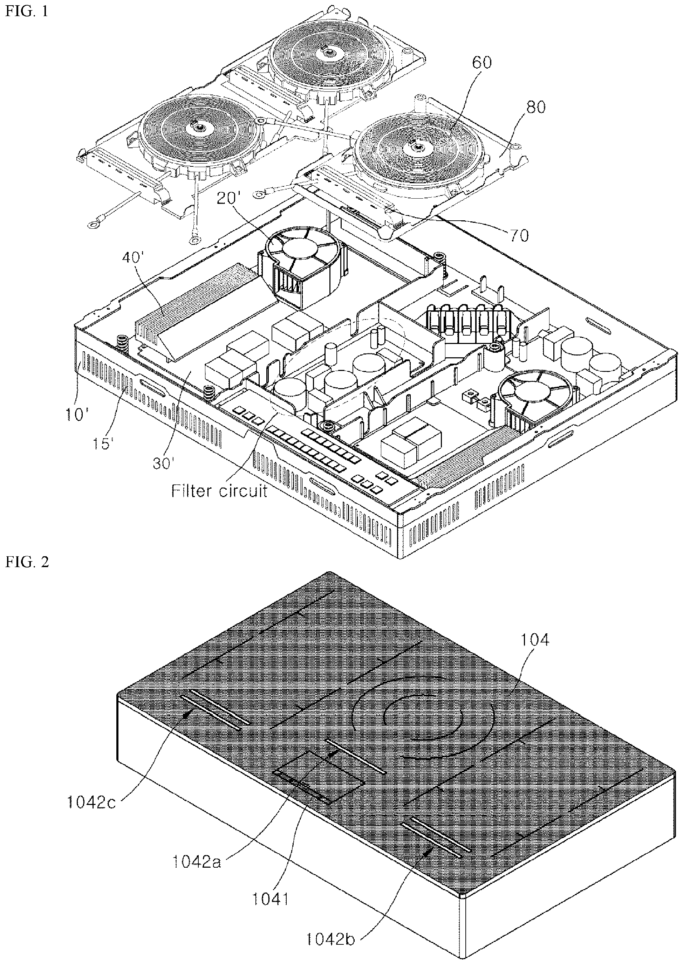

FIG. 1 is a view showing a configuration in an induction heating device of the related art.

FIG. 1 is presented in Korean Patent Publication No. 10-2019-0111660.

Referring to FIG. 1, a filter circuit includes a plurality of filters, and is disposed at a center of a case 10. That is, the filter circuit is disposed right below a working coil 60. Accordingly, noise generated by the working coil 60 affects the filter circuit due to the position of the filter circuit.

Additionally, when a temperature of the filter circuit itself increases, a noise reduction effect lessens. Particularly, when the filter circuit is disposed below a high-power working coil 60, the temperature of the filter circuit itself further increases, and the filter circuit cannot perform the function of noise filtering properly due to an increase in the temperature.
US 2020/053838 A1 relates to an induction heating device which includes a first power module supplying power for driving to at least one of a first working coil and an inner coil, a second power module supplying power for driving to at least one of a second working coil and an outer coil, and a control unit controlling supply of power by the first power module and the second power module. The control unit may cut off supply of power to the outer coil when an instruction for heating to at least one of a first heating area and a second heating area, and an instruction for heating to a third heating area are input. WO 2018/199613 A1 discloses an electric range according to the preamble of claim 1.

### SUMMARY

### Technical Problem

The present disclosure is directed to an electric range that may efficiently reduce noise caused by a magnetic field generated in a working coil.

The present disclosure is also directed to an electric range that may optimize electromagnetic compatibility.

The present disclosure is also directed to an electric range in which a filter circuit may be disposed in an optimal position.

Aspects are not limited to the above ones, and other aspects and advantages that are not mentioned above can be clearly understood from the following description and can be more clearly understood from the embodiments set forth herein.

### Technical Solution

The object is solved by the features of the independent claims Preferred embodiments are given in the dependent claims.

According to present invention an electric range is provided, comprising a case, a cover plate coupled to an upper end of the case, and allowing an object to be heated to be placed on an upper surface thereof; at least two working coils disposed below the cover plate, and configured to heat the object to be heated; a base plate disposed at a middle end of the case, and provided with the plurality of working coils in an upper portion thereof; one or more driving circuits disposed at a lower end of the case, and configured to drive the working coils; and a filter circuit disposed at the lower end of the case, and configured to reduce noise generated by the plurality of working coils.

According to the present invention, the one or more working coils include a high-power working coil and at least one first low-power working coil.

In some or more embodiments, the filter circuit may be outside or not overlapped or spaced apart from the high-power working coil, preferably, the filter circuit may be disposed below the at least one first low-power working coil.

In some or more embodiments, the at least one driving circuit may be disposed below the high-power working coil.

In some or more embodiments, the plurality of working coils may further include at least of second low-power working coil.

In some or more embodiments, at least one remaining driving circuit among the plurality of driving circuits (110a, 110b, 110c) is disposed below the at least of second low-power working coil.

In some or more embodiments, the electric range may further comprising a power feeder.

Preferably the power feeder may be disposed adjacent to the filter circuit at the lower end of the case.

Preferably, the power feeder may be connected with an external power source.

Preferably, an electric wire may be electrically connected the power feeder and the filter circuit.

Preferably, the at least one first low-power working coil and the filter circuit may be disposed at any one of edges of the lower end of the case.

In some or more embodiments, the electric wire may be disposed between the any one of edges of the lower end of the case and the filter circuit.

By having the power feeder and the filter unit at one side of the electric range the distance to the high power coil is maximized and the power feeder is close to the filter unit, so the connection wire is also short and can be placed at maximum distance to the high power coil. Thus, the possibility to receive a high power magnetic field is decreased and thereby the influence in the power supply to the filter unit is also not effected to keep the influence of the high power coil on the filter and its power supply as low as possible.

In some or more embodiments, the plurality of working coils may include a first working coil in a central portion of the base plate, and at least one second third working coil on a right and/or left side of the first working coil.

Preferably, the first working coil may be the high-power working coil.

Preferably, the second, third working coils or the fourth and fifth working coils correspond to the at least one low-power working coil and may be located at the left and/r right side of the first working coil being provided at the central portion the electric range.

In some or more embodiments, the filter circuit may be disposed below any one of left and right sides of the low-power working coil.

Preferably, the plurality of driving circuits may be disposed on the other of the left and right sides of the case and below the base plate and below the central portion of the base plate.

Preferably, the filter circuit may include a first filter circuit configured to reduce noise generated by the first working coil, a second filter circuit configured to reduce noise generated by the second and third working coils, and a third filter circuit configured to reduce noise generated by the fourth and fifth working coils.

So, there is one filter unit for the high power working coil.

There may be one filter unit for two low poser working coils.

Preferably, the first, second and third filter circuits may disposed in a single column at any one of the sides.

In some or more embodiments, the first filter circuit may be disposed in a middle of the column.

The filter circuit may be disposed on the left side of the base plate.

The second filter circuit may be disposed on a top of the column

The third filter circuit may be disposed on a bottom of the column.

Alternatively, the filter circuit may be disposed on the right side of the base plate.

The second filter circuit may be disposed on the bottom of the column.

The third filter circuit may be disposed on the top of the column.

In some or more embodiments, the first filter circuit may include first and second filter cores.

In some or more embodiments, the second filter circuit may include third and fourth filter cores.

The third filter circuit may include fifth and sixth filter cores.

In some or more embodiments, the electric range may further comprise at least one an air blowing fan configured to cool an inside of the case.

The at least one air blowing fan may be disposed adjacent to the filter circuit.

Preferably, air generated by the one or more air blowing fans may be supplied to the one or more filter circuits.

In another aspect of the disclosure an electric range is provided, comprising: a case, a plurality of working coils disposed at an upper end of the case, and configured to heat an object to be heated, a filter circuit disposed at any one of edges of a lower end of the case and configured to reduce noise generated by the plurality of working coils, a power feeder disposed adjacent to the filter circuit at any one of the edges of a lower end of the case and connected with an external power source; an electric wire configured to electrically connect the power feeder and the filter circuit, wherein the electric wire is disposed between the any one of edges of the lower end of the case and the filter circuit.

In an electric range according to the present disclosure, one or more filter circuits may be disposed to gather at an edge of a lower end of a case, thereby reducing noise generated by a working coil as much as possible.

In the electric range, the filter circuit may be spaced a maximum distance apart from a plurality of working coils, thereby improving performance of the filter circuit.

The electric range may be provided with the plurality of working coils including a high-power working coil and a low-power working coil.

The filter circuit may be disposed below the low-power working coil, thereby effectively reducing noise generated mainly by the high-power working coil.

In the electric range, the filter circuit may be disposed adjacent to a power feeder configured to be supplied with an external power from an external power source, thereby improving performance of noise filtering.

In the electric range, an electric wire, configured to electrically connect the power feeder and the filter circuit, may be disposed between an outer circumferential surface of the case and the filter circuit, thereby minimizing an effect of noise generated by the plurality of working coils.

In the electric range, the filter circuit may be disposed at a point where air output from an air blowing fan is supplied, thereby reducing a temperature of the filter circuit and improving the performance of the filter circuit.

### Advantageous Effect

According to the present disclosure, noise caused by a magnetic field generated in any one of the working coils may be reduced effectively.

According to the present disclosure, a filter circuit may be spaced a maximum distance apart from a working coil to optimize electromagnetic compatibility.

According to the present disclosure, the filter circuit may be disposed at an optimal position of an electric range.

Specific effects are described along with the above-described effects in the section of Detailed Description.

### BRIEF DESCRIPTION OF DRAWING

The accompanying drawings constitute a part of this specification, illustrate one or more embodiments of the present disclosure, and together with the specification, explain the present disclosure, wherein:
FIG. 1 is a view showing a configuration in an induction heating device of the related art;
FIG. 2 is a perspective view showing an induction heating device according to one embodiment;
FIGS. 3 to 6 are perspective views showing the induction heating device in FIG. 2 without some components;
FIG. 7 is a plane view showing a configuration in an induction heating device according to one embodiment; and
FIG. 8 is a view for explaining a concept in which air output from an air blowing fan is supplied to a filter circuit, according to one embodiment.

### DETAILED DESCRIPTION

The above-described aspects, features and advantages are specifically described hereunder with reference to the accompanying drawings such that one having ordinary skill in the art to which the present disclosure pertains can easily implement the technical idea of the disclosure. In the *disclosure, detailed description* of known technologies in relation to the disclosure *is* omitted if it is deemed to *make* the *gist* of the *disclosure* unnecessarily *vague.* Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

When one component is described as being "in an upper portion (or a lower portion)" of another component, or "on (or under)" another component, one component can be placed on the upper surface (or under the lower surface) of another component, and an additional component may be interposed between another component and one component on (or under) another component.

When one component is described as being "connected", "coupled", or "connected" to another component, one component can be directly connected, coupled or connected to another component; however, it is also to be understood that an additional component can be "interposed" between the two components, or the two components can be "connected", "coupled", or "connected" through an additional component.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "have," set forth herein, are not interpreted as necessarily including all the stated components or steps but can be interpreted as including some of the stated components or steps or can be interpreted as further including additional components or steps.

Throughout the disclosure, the terms "A and/or B" as used herein can denote A, B or A and B, and the terms "C to D" can denote C or greater and D or less, unless stated to the contrary.

Below, an electric range is described with reference to several embodiments.

The electric range in the disclosure may include an electric resistance-type electric range and an induction heating-type electric range (i.e., an induction heating device). For convenience, an induction heating device, provided with a working coil as a heating unit, is described as an example during description of the embodiments. However, embodiments are not limited to those set forth herein.

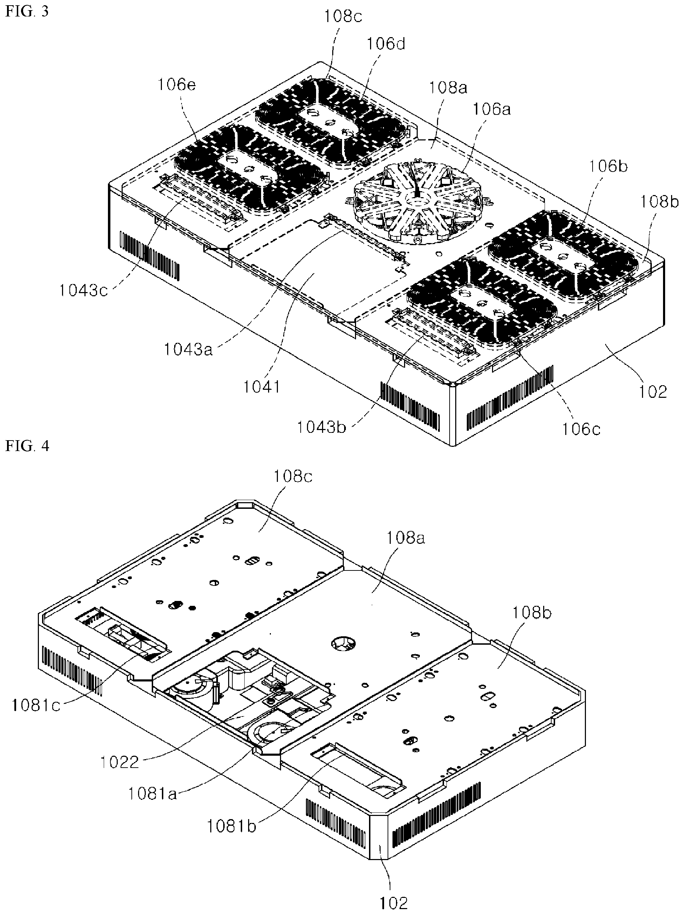

FIG. 2 is a perspective view showing an induction heating device 100 according to one embodiment. FIGS. 3 to 6 are perspective views showing the induction heating device 100 in FIG. 2 without some components.

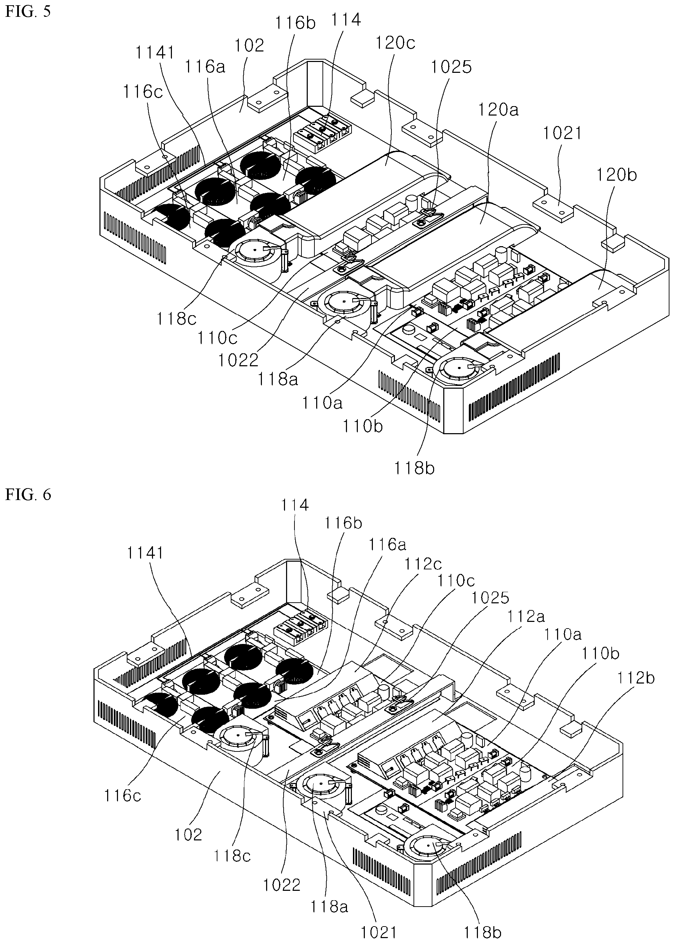

Specifically, FIG. 3 is a view showing the induction heating device 100 in FIG. 2 without a cover plate 104, FIG. 4 is a view showing the induction heating device 100 in FIG. 2 without a cover plate 104 and a working coil 106a, 106b, 106c, 106d, 106e, FIG. 5 is a view showing the induction heating device 100 in FIG. 2 without a cover plate 104, a working coil 106a, 106b, 106c, 106d, 106e, and a base plate 108a, 108b, 108c, and FIG. 6 is a view showing the induction heating device 100 in FIG. 2 without a cover plate 104, a working coil 106a, 106b, 106c, 106d, 106e, a base plate 108a, 108b, 108c and an air guide 120a, 120b, 120c.

Referring to FIGS. 2 to 6, the induction heating device 100 according to one embodiment may include a case 102, a cover plate 104, a working coil 106a, 106b, 106c, 106d, 106e, a base plate 108a, 108b, 108c, a driving circuit 110a, 110b, 110c, a heat sink 112a, 112b, 112c, a power feeder 114, a filter circuit 116a, 116b, 116c, an air blowing fan 118a, 118b, 118c, and an air guide 120a, 120b, 120c.

The case 102 may protect components in the induction heating device 100. For example, the case 102 may be made of aluminum or any other metal but not limited. The case 102 may be thermally insulated to prevent heat, generated by the working coil 106a, 106b, 106c, 106d, 106e, from leaking outward and to protect the user from being hurt.

The cover plate 104 may be coupled to an upper end of the case 102 to shield an inside of the case 102, and an object to be heated (not illustrated, an object to be heated by at least one of the working coils 106a, 106b, 106c, 106d, 106e) may be placed on an upper surface of the cover plate 104.

An object to be heated such as a cooking vessel may be placed on the upper surface of the cover plate 104, and heat generated by the working coil 106a, 106b, 106c, 106d, 106e may be delivered to the object to be heated through the upper surface of the cover plate104.

The cover plate 104 may be made of glass but not limited.

An input interface 1041 configured to receive an input from a user may be disposed on the upper surface of the cover plate 104.

The input interface 1041 may be buried into the upper surface of the cover plate 104 and may display a specific image. The input interface 1041 may receive a touch input from the user, and the induction heating device 100 may be driven based on the received touch input. One or more parts of the input interface 1041, e.g. a control button or knob might also located the case 102 and only the display portion might be located on the cover plate.

Specifically, the input interface 1041 may be a module for controlling and/or inputting a heating intensity and/or a heating period and the like desired by the user.

It may be implemented as a physical button and/or a touch panel and the like.

Additionally, the input interface 1041 may display a driving state of the induction heating device 100 or any other suitable information for operating the electric range.

For example, the input interface 1041 may be a display, e.g. a liquid crystal display (LCD) or an LED display but not limited.

On or more light display areas 1042a, 1042b, 1042c may be formed on the upper surface of the cover plate 104. One or more light source units 1043a, 1043b, 1043c may be disposed below the cover plate 104, and light emitted from the one or more light source units 1043a, 1043b, 1043c may be delivered to the user through the one or more light display areas 1042a, 1042b, 1042c.

The working coil 106a, 106b, 106c, 106d, 106e may be considered as a heating unit that heats an object to the heated, and may be disposed in the case 102.

Each of the one or more working coils 106a, 106b, 106c, 106d, 106e may include a wire that is wound multiple times in a ring shape, and may generate an AC magnetic field.

Additionally, a mica sheet and/or a ferrite core may be consecutively disposed on a lower side of the working coil 106a, 106b, 106c, 106d, 106e.

The ferrite core may be fixed, preferably via the mica sheet, through a sealant, and may diffuse the AC magnetic field generated by the working coil 106a, 106b, 106c, 106d, 106e.

The mica sheet may be fixed to the working coil 106a, 106b, 106c, 106d, 106e and/or the ferrite core through a sealant, and may prevent a direct delivery of the heat, generated by the working coil 106a, 106b, 106c, 106d, 106e, to the ferrite core.

A plurality of working coils 106a, 106b, 106c, 106d, 106e may be provided. The plurality of working coils 106a, 106b, 106c, 106d, 106e may include a first working coil 106a disposed in a central portion of the case 102. One or more low power working coils might be located around the central portion.

A second working coil 106b and a third working coil 106c may be disposed on a right side of the first working coil 106a.

A fourth working coil 106d and a fifth working coil 106e may be disposed on a left side of the first working coil 106a.

The second working coil 106b and the third working coil 106c may be disposed on the right side of the first working coil 106a in an up-down direction.

The fourth working coil 106d and the fifth working coil 106e may be disposed on the left side of the first working coil 106a in the up-down direction.

The low power working coils may have different size. Also other forms. E.g. oval forms for the working coils are possible.

The first working coil 106a may be a high-power working coil, and the second working coil 106b, the third working coil 106c, the fourth working coil 106d and the fifth working coil 106e may be a low-power working coil.

For example, the first working coil 106a may be a dual high-power working coil, and the second working coil 106b, the third working coil 106c, the fourth working coil 106d and the fifth working coil 106e may be a single low-power working coil. The first working coil 106a may have a heavy weight, and may have a maximum output of 7000 Kw. The high output and the low output may be defined based on a predetermined reference output.

The induction heating device 100 according to one embodiment may perform the function of wireless power transmission based on the configurations and features described above.

Technologies for wirelessly supplying power have been developed and have been used for a wide range of electronic devices. A battery of an electronic device, to which the wireless power transmitting technology is applied, can be charged only by being placed on a charge pad without connecting to an additional charge connector. Accordingly, the electronic device, to which the wireless power transmitting technology is applied, requires no cord or no charger, thereby ensuring improved mobility and a reduced size and weight.

The wireless power transmitting technology can be broadly classified as an electromagnetic induction technology using a coil, a resonance technology using resonance, and a radio emission technology for converting electric energy into microwaves and delivering the microwaves, and the like. In the electromagnetic induction technology, power is transmitted using electromagnetic induction between a primary coil (e.g., a working coil) included in an apparatus for wirelessly transmitting power and a secondary coil included in an apparatus for wirelessly receiving power.

The theory of the induction heating technology of the induction heating device 100 is substantially the same as that of the electromagnetic induction-based wireless power transmission technology, in that an object to be heated is heated using electromagnetic induction. Accordingly, the induction heating device 100 according to one embodiment may perform the function of wireless power transmission as well as the function of induction heating.

The base plate 108a, 108b, 108c may be disposed at a middle end of the case 102, and the plurality of working coils 106a, 106b, 106c, 106d, 106e may be disposed in an upper portion of the base plate108a, 108b, 108c. The base plate 108a, 108b, 108c may support the plurality of working coils 106a, 106b, 106c, 106d, 106e that are heavy, and may help the plurality of working coils 106a, 106b, 106c, 106d, 106e to be mounted. The input interface 1041 and the light source unit 1043 may be further disposed in the upper portion of the base plate 108a, 108b, 108c.

According to one embodiment, a plurality of base plates 108a, 108b, 108c may be provided but not limited. Alternatively, a single base plate may be disposed in the case 102.

According to one embodiment, the plurality of base plates 108a, 108b, 108c may include a first base plate 108a, a second base plate 108b, and a third base plate 108c.

The first base plate 108a, the second base plate 108b, and the third base plate 108c may be disposed at the middle end of the case 102 side by side.

The first base plate 108a may be disposed in a central portion of the middle end of the case 102. The first working coil 106a may be disposed in an upper portion of the first base plate 108a.

The input interface 1041, and a first light source unit 1043a corresponding to the first working coil 106a may be further disposed in the upper portion of the first base plate 108a. The first base plate 108a may have a through hole A 1081a for installing the input interface 1041 and the first light source unit 1043a.

The second base plate 108b may be disposed on a right side of the first base plate 108a at the middle end of the case 102. The second working coil 106b and the third working coil 106c may be disposed in an upper portion of the second base plate 108b.

A second light source unit 1043b corresponding to the second working coil 106b and the third working coil 106c may be further disposed in the upper portion of the second base plate 108b. In the upper portion of the second base plate 108b, the second working coil 106b, the third working coil 106c and the second light source unit 1043b may be consecutively disposed. The second base plate 108b may have a through hole B 1081b for installing the second light source unit 1043b.

The third base plate 108c may be disposed on a left side of the first base plate 108a at the middle end of the case 102. The fourth working coil 106d and the fifth working coil 106e may be disposed in an upper portion of the third base plate108c.

A third light source unit 1043c corresponding to the fourth working coil 106d and the fifth working coil 106e may be further disposed in the upper portion of the third base plate108c. In the upper portion of the third base plate108c, the fourth working coil 106d, the fifth working coil 106e and the third light source unit 1043c may be consecutively disposed. The third base plate 108c may have a through hole C 1081c for installing the third light source unit 1043c.

The case 102 may have a plurality of mounting portions 1021 for mounting the plurality of base plates 108a, 108b, 108c at a part of an outer circumferential surface of the case 102. That is, edges of the plurality of base plates 108a, 108b, 108c may be mounted onto a top of the plurality of mounting portions 1021. Accordingly, the plurality of base plates 108a, 108b, 108c may be disposed at the middle end of the case 102. The mounting portions 1021 might be bend portion of the case being bent inside the case to thereby provide a supporting surface for the one or more base plates.

The one or more filter circuits 116a, 116b, 116c, the one or more driving circuit 110a, 110b, 110c and the one or more air blowing fans 118a, 118b, 118c are located below the one or more base plates 108a, 108b, 108c inside the case 102.

The case 102 may include a bracket 1022 in a central portion of a lower end of the case 102. The bracket 1022 may be disposed in a central portion of a lower side of the first base plate 108a, and may prevent sagging of a lower surface of the first base plate 108a, caused by weight of the first base plate 108a. The weight of the first base plate 108a may include the weight of the first working coil 106a located at the upper portion of the first base plate 108a.

The bracket 1022 may include at least one elastic element 1025 on a top of the bracket 1022. For example, the elastic element 1025 may be a leaf spring. An upper end of at least one elastic element 1025 may contact the lower surface of the first base plate 108a, and may prevent sagging of the lower surface of the first base plate 108a.

The one or more driving circuits 110a, 110b, 110c may control driving of the one or more working coils 106a, 106b, 106c, 106d, 106e that are heating units, and may further control driving of components such as an input interface 1041 and the like of the induction heating device 100.

The driving circuit 110a, 110b, 110c may include various components in relation to the driving of the working coils 106a, 106b, 106c, 106d, 106e. The components may include a power supply configured to supply AC power, a rectifier configured to rectify AC power of the power supply into DC power, an inverter configured to convert DC power, rectified by the rectifier, into resonance current as a result of a switching operation and supply the resonance current to the working coil 106, a microcomputer (i.e., a micom) configured to control the inverter and components in relation to driving of the inverter, a relay or a semiconductor switch configured to turn on or turn off the working coils 106a, 106b, 106c, 106d, 106e, and the like.

The driving circuit 110a, 110b, 110c may include a first driving circuit 110a, a second driving circuit 110b, and a third driving circuit 110c. The first driving circuit 110a may be disposed on a right side of the lower end of the case 102 with respect to the bracket 1022 and may control driving of the first working coil 106a. The second driving circuit 110b may be disposed on a right side of the first driving circuit 110a and may control driving of the second working coil 106b and the third working coil 106c. The third driving circuit 110c may be disposed on a left side of the lower end of the case 102 with respect to the bracket 1022 and may control driving of the fourth working coil 106d and the fifth working coil 106e.

The heat sink 112a, 112b, 112c may be disposed over parts of the driving circuits 110a, 110b, 110c and may prevent an increase in temperatures of components disposed at the parts of the driving circuits 110a, 110b, 110c.

The heat sink 112a, 112b, 112c may include a first heat sink 112a, a second heat sink 112b, and a third heat sink 112c. The first heat sink 112a may prevent an increase in temperatures of components installed in a part of the first driving circuit 110a, the second heat sink 112b may prevent an increase in temperatures of components installed in a part of the second driving circuit 110b, and the third heat sink 112c may prevent an increase in temperatures of components installed in a part of the third driving circuit 110c.

The power feeder 114 may supply an external power from an external power source to the induction heating device 100. The power feeder 114 may be implemented as a terminal block.

The power feeder 114 may be disposed at any one of edges of the lower end of the case 102. For example, the power feeder 114 may be disposed at an upper end of the left side of the lower end of the case 102.

The filter circuit 116a, 116b, 116c may be disposed at any one of the edges of the lower end of the case 102, and may reduce noise made by the plurality of working coils 106a, 106b, 106c, 106d, 106e.

The filter circuit 116a, 116b, 116c may include a first filter circuit 116a, a second filter circuit 116b, and a third filter circuit 116c.

The first filter circuit 116a may reduce noise made by the first working coil 106a. The second filter circuit 116b may reduce noise made by the second working coil 106b and the third working coil 106c. The third filter circuit 116c may reduce noise made by the fourth working coil 106d and the fifth working coil 106e.

The one or more air blowing fans 118a, 118b, 118c may pull down a temperature inside the case 102. Accordingly, the air blowing fan 118a, 118b, 118c may lower a temperature of various components installed in the driving circuits 110a, 110b, 110c.

The air blowing fan 118a, 118b, 118c may include a first air blowing fan 118a, a second air blowing fan 118b, and a third blow fan 118c.

The first air blowing fan 118a may cool various components installed in the first driving circuit 110a and may further cool the first light source unit 1043a and the input interface 1041. Particularly, the first air blowing fan 118a may deliver air (wind) for cooling to the first heat sink 112a over the first driving circuit 110a.

The second air blowing fan 118b may cool various components installed in the second driving circuit 110b and may further cool the second light source unit 1043b. Particularly, the second air blowing fan 118b may deliver air for cooling to the second heat sink 112b over the second driving circuit 110b.

The third air blowing fan 118c may cool various components installed in the third driving circuit 110c and may further cool the third light source unit 1043c. Particularly, the third air blowing fan 118c may deliver air for cooling to the third heat sink 112c over the third driving circuit 110c.

The air guide 120a, 120b, 120c may guide air generated by the air blowing fans 118a, 118b, 118c.

The air guide 120a, 120b, 120c may include a first air guide 120a, a second air guide 120b and a third guide 120c.

The first air guide 120a may be disposed to encircle the first heat sink 112a installed in a part of the first driving circuit 110a and may guide (deliver) air, output from the first air blowing fan 118a, to the first heat sink 112a.

The second air guide 120b may be disposed to encircle the second heat sink 112b installed in a part of the second driving circuit 110b and may guide air, output from the second air blowing fan 118b, to the second heat sink 112b.

The third air guide 120c may be disposed to encircle the third heat sink 112c installed in a part of the third driving circuit 110c and may guide air, output from the third air blowing fan 118c, to the third heat sink 112c.

The induction heating device 100 according to one embodiment has the configurations and features described above. Below, the filter circuit 116a, 116b, 116c according to the present disclosure is described specifically.

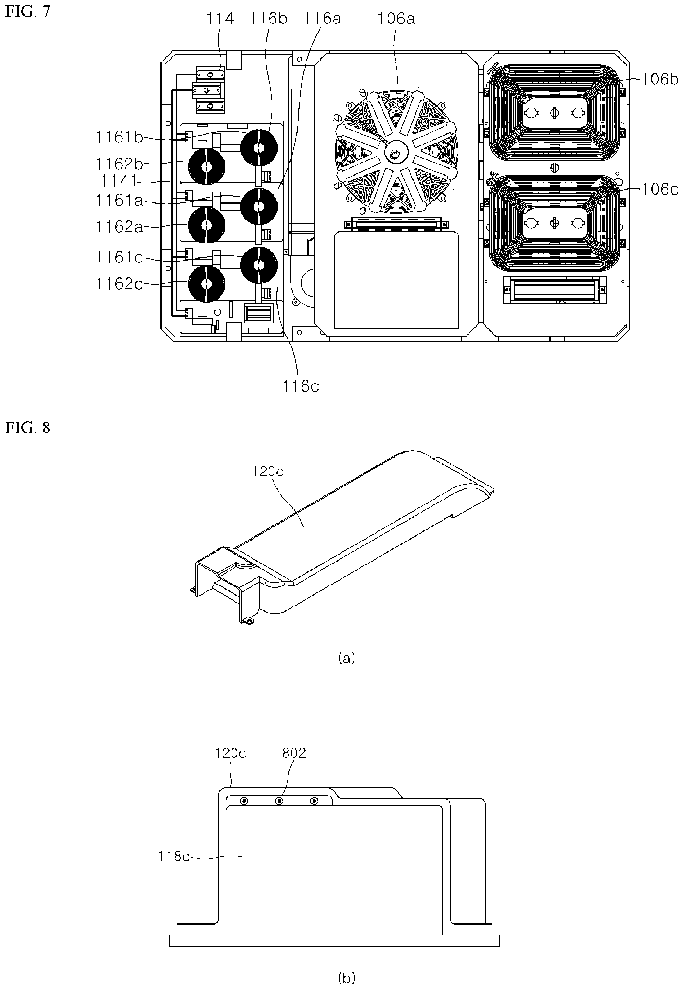

FIG. 7 is a plane view showing a configuration in an induction heating device 100 according to one embodiment.

In FIG. 7, the fourth working coil 106d, the fifth working coil 106e, the third light source unit 1043c and the third base plate 108c, illustrated in FIG. 2, are omitted, for convenience of description.

The filter circuit 116a, 116b, 116c may be disposed at any one of the edges of the lower end of the case 102.

For example, the filter circuit 116a, 116b, 116c may be disposed at a left edge of the lower end of the case 102 referring to FIGS. 5, 6 and 7, but not limited. The filter circuit 116a, 116b, 116c may also be disposed at a right edge of the lower end of the case 102. That is, the filter circuit 116a, 116b, 116c may be disposed below any one of the left and right sides of the base plate 108a, 108b, 108c.

Being below any one of the left and right sides may correspond being below the second and third working coils 106b, 106c or the fourth and fifth working coils 106d as a low-power working coil. In other words, the filter circuit 116a, 116b, 116c may not be disposed below the high-power working coil, but may be disposed below the low-power working coil.

Referring to FIGS. 5 and 6, the driving circuit 110a, 110b, 110c may be disposed below the first, second and third working coils 106a, 106b, 106c.

In summary, the filter circuit 116a, 116b, 116c may be disposed below at least one first low-power working coil (e.g., the fourth and fifth working coils 106d, 106e) among a plurality of low-power working coils. Additionally, at least one driving circuit (e.g., the third driving circuit 110c) of the driving circuits 110a, 110b, 110c may be disposed below the high-power working coil (e.g., the first working coil 106a). At least one remaining driving circuit (e.g., the second and third driving circuits 110b, 110c) among the driving circuits 110a, 110b, 110c may be disposed below at least one second low-power working coil (e.g., the first and second working coils 106a, 106b) among the plurality of low-power working coils.

The filter circuit 116a, 116b, 116c, as described above, may include the first filter circuit 116a, the second filter circuit 116b and the third filter circuit 116c. That is, the first filter circuit 116a, the second filter circuit 116b and the third filter circuit 116c may gather and be disposed at a single point instead of being spaced and disposed at different positions. In this case, the first filter circuit 116a, the second filter circuit 116b and the third filter circuit 116c may be disposed in a single column.

In case that the filter circuit 116a, 116b, 116c is disposed on the left side of the lower end of the case 102, the first filter circuit 116a may be disposed in a middle of the column, the second filter circuit 116b may be disposed on a top of the column, and the third filter circuit 116c may be disposed on a bottom of the column.

In case that the filter circuit 116a, 116b, 116c is disposed on the right side of the lower end of the case 102, the first filter circuit 116a may be disposed in the middle of the column, the second filter circuit 116b may be disposed on the bottom of the column, and the third filter circuit 116c may be disposed on the top of the column.

The first filter circuit 116a may reduce noise made by the first working coil 106a in the central portion of the case 102. That is, the first filter circuit 116a may reduce the noise of the first working coil 106a as a high-power working coil disposed on the first base plate 108a.

The first filter circuit 116a may include a first filter core 1161a and a second filter core 1162a. The first filter core 1161a and the second filter core 1162a may perform noise filtering.

The second filter circuit 116b may reduce noise made by the second working coil 106b and the third working coil 106c on the right side of the first working coil 106a. That is, the second filter circuit 116b may reduce the noise of the second working coil 106b and the third working coil 106c that are low-power working coils disposed on the second base plate 108b in the up-down direction.

The second filter circuit 116b may include a third filter core 1161b and a fourth filter core 1162b. The third filter core 1161b and the fourth filter core 1162b may perform noise filtering.

The third filter circuit 116c may reduce noise made by the fourth working coil 106d and the fifth working coil 106e disposed on the left side of the first working coil 106a. That is, the third filter circuit 116c may reduce the noise of the fourth working coil 106d and the fifth working coil 106e that are low-power working coils disposed on the third base plate 108c in the up-down direction.

The third filter circuit 116c may include a fifth filter core 1161c and a sixth filter core 1162c. The fifth filter core 1161c and the sixth filter core 1162c may perform noise filtering.

The power feeder 114 may be a terminal block configured to supply external power from an external power source to the induction heating device 100.

The power feeder 114 may be at an edge of the lower end of the case 102 where the filter circuit 116a, 116b, 116c is disposed, and may be disposed adjacent to the filter circuit 116a, 116b, 116c.

That is, when the power feeder 114 is disposed at the left edge of the lower end of the case 102, the filter circuit 116a, 116b, 116c may be disposed at the left edge of the lower end of the case 102, and may be disposed adjacent to a lower side of the power feeder 114. When the power feeder 114 is disposed at the right edge of the lower end of the case 102, the filter circuit 116a, 116b, 116c may be disposed at the right edge of the lower end of the case 102, and may be disposed adjacent to the lower side of the power feeder 114.

The power feeder 114 may be electrically connected to the filter circuit 116a, 116b, 116c through an electric wire 1141. The electric wire 1141 may be disposed between an outer circumferential surface of the case 102 and the filter circuit 116a, 116b, 116c.

That is, when the power feeder 114 and the filter circuit 116a, 116b, 116c are disposed at the left edge of the lower end of the case 102, the electric wire 1141 may be disposed between an outer circumferential surface of a left side of the case 102 and the filter circuit 116a, 116b, 116c. When the power feeder 114 and the filter circuit 116a, 116b, 116c are disposed at the right edge of the lower end of the case 102, the electric wire 1141 may be disposed between an outer circumferential surface of a right side of the case 102 and the filter circuit 116a, 116b, 116c.

The filter circuit 116a, 116b, 116c may be disposed adjacent to the air blowing fan 118a, 118b, 118c. In this case, air output from the air blowing fan 118a, 118b, 118c may be supplied to the filter circuit 116a, 116b, 116c. Accordingly, a temperature of the filter circuit 116a, 116b, 116c may decrease, and performance of the filter circuit 116a, 116b, 116c may increase.

FIG. 8 is a view for explaining a concept in which air output from an air blowing fan 118a, 118b, 118c is supplied to a filter circuit 116a, 116b, 116c.

For convenience of description, the concept of supplying air is described under the assumption that the filter circuit 116a, 116b, 116c is disposed on a left side of the third air guide 120c.

FIG. 8(a) is a perspective view showing a third air guide 120c, and FIG. 8(b) is a cross-sectional view showing a portion where a third air guide 120c and a third air blowing fan 118c are connected.

Referring to FIG. 8, one end of the third air guide 120c may be connected to an output end of the third air blowing fan 118c, and air output from the third air blowing fan 118c may flow through the third air guide 120c.

In this case, a height of one end of the third air guide 120c may be greater than a height of the third air blowing fan 118c. Some of the air 802 generated by the third air blowing fan 118c may escape out of the third air guide 120c, due to a hit of the air output from the third air blowing fan 118c against the third heat sink 112c, or due to inner air pressure between one end of the third air guide 120c and the third air blowing fan 118c. Accordingly, some of the air 802 may cool the filter circuit 116a, 116b, 116c. The third air guide 120c may also have filter air channels for directly cooling the filter circuits 116a, 116b, 116c, wherein the air is branched on the third air guide 120c and guided into the filter air channels for providing cool air to the filter circuits 116a, 116b, 116c.

With reference to the above description, a position at which the filter circuit 116a, 116b, 116c is disposed, is described hereunder.

When a distance between the filter circuit 116a, 116b, 116c and the working coil 106a, 106b, 106c, 106d, 106e becomes shorter, the performance of noise filtering becomes inferior. That is, when the filter circuit 116a, 116b, 116c is disposed close to the working coil 106a, 106b, 106c, 106d, 106e, the temperature of the filter circuit 116a, 116b, 116c may increase, and since the filter circuit 116a, 116b, 116c is exposed to a high-intensity magnetic field, the performance of noise filtering may deteriorate.

To improve the performance of noise filtering, the filter circuit 116a, 116b, 116c needs to be spaced as far from the working coil 106a, 106b, 106c, 106d, 106e as possible. That is, according to the present disclosure, the filter circuit 116a, 116b, 116c may be disposed such that the filter circuit 116a, 116b, 116c is spaced a maximum distance apart from the working coil 106a, 106b, 106c, 106d, 106e.

Particularly, the first working coil 106a in the central portion of the case 102 may generate the highest level of noise because the first working coil 106a is a high-power working coil. According to the present disclosure, the first filter circuit 116a may be disposed such that the first filter circuit 116a is spaced a maximum distance apart from the first working coil 106a in the central portion. That is, the first filter circuit 116a may be disposed at an edge area of the case 102. Additionally, the second filter circuit 116b and the third filter circuit 116c, as described above, may be disposed far away from the second and fifth working coils 106b, 106c, 106d, 106e.

In summary, the filter circuits 116a, 116b, 116c may gather and be disposed at a single place. Additionally, the filter circuit 116a, 116b, 116c may be disposed below the second and third working coils 106b, 106c as a low-power working coil or below the fourth and fifth working coils 106d, 106e as a low-power working coil, may not be disposed below the first working coil 106a as a high-power working coil. Accordingly, the filter circuit 116a, 116b, 116c may be disposed such that the filter circuit 116a, 116b, 116c is spaced a maximum distance apart from the working coil 106a, 106b, 106c, 106d, 106e, and electromagnetic compatibility may be optimized and noise filtering may be maximized.

Additionally, when a distance between the power feeder 114 and the filter circuit 116a, 116b, 116c becomes greater, noise may increase. Accordingly, the filter circuit 116a, 116b, 116c may gather and be disposed at a single point adjacent to the power feeder 114 to improve the performance of noise filtering.

Further, the electric wire 1141 configured to connect the power feeder 114 and the filter circuit 116a, 116b, 116c may also be disposed at the farthest point away from the working coil 106a, 106b, 106c, 106d, 106e to minimize an effect of the magnetic field.

Furthermore, as the temperature of the filter circuit 116a, 116b, 116c becomes lower, the performance of noise filtering becomes better. Accordingly, the filter circuit 116a, 116b, 116c may be disposed at a point where air output from the air blowing fan 118a, 118b, 118c is supplied.

To sum up, according to the present disclosure, noise caused by a magnetic field generated in the working coil may be reduced efficiently, electromagnetic compatibility may be optimized, and the filter may be disposed at an optimal position of the electric range.

The embodiments are described above with reference to a number of illustrative embodiments thereof. However, the present disclosure is not intended to limit the embodiments and drawings set forth herein, and numerous other modifications and embodiments can be devised by one skilled in the art without departing from the disclosure. Further, the effects and predictable effects based on the configurations in the disclosure are to be included within the range of the disclosure though not explicitly described in the description of the embodiments

## Claims

1. An electric range, comprising:
a case (102);
a cover plate (104) coupled to an upper end of the case (102);
one or more base plates (108a, 108b, 108c) disposed below the cover plate (104);
a plurality of working coils (106a, 106b, 106c, 106d, 106e) disposed above the one or more base plates (108a, 108b, 108c) and below the cover plate (104), and configured to heat an object being placed on the cover plate (104) for being heated;
one or more driving circuits (110a, 110b, 110c) disposed below the one or more base plates (108a, 108b, 108c) and configured to drive the working coils (106a, 106b, 106c, 106d, 106e); and
a filter circuit (116a, 116b, 116c) disposed below the one or more base plates (108a, 108b, 108c) and configured to reduce electromagnetic compatibility, EMC, -related noise generated by the working coils (106a, 106b, 106c, 106d, 106e), **characterised in that**
the working coils (106a, 106b, 106c, 106d, 106e) include a high-power working coil and at least one first low-power working coil, and
the filter circuit (116a, 116b, 116c) is disposed below the at least one first low-power working coil.

2. The electric range of claim 1, wherein at least one driving circuit of the one or more driving circuits (110a, 110b, 110c) is disposed below the high-power working coil.

3. The electric range of claim 2, wherein the working coils (106a, 106b, 106c, 106d, 106e) further include at least one second low-power working coil, wherein at least one remaining driving circuit among the driving circuits (110a, 110b, 110c) is disposed below the at least one second low-power working coil.

4. The electric range of claim 1, 2 or 3, further comprising a power feeder (114) disposed below the one or more base plates (108a, 108b, 108c) and adjacent to the filter circuit (116a, 116b, 116c) at the lower end of the case (102), and connected to an external power source; and an electric wire (1141) configured to electrically connect the power feeder (114) and the filter circuit (116a, 116b, 116c).

5. The electric range of any one of the preceding claims, wherein the at least one first low-power working coil and the filter circuit (116a, 116b, 116c) are disposed adjacent to any one of the edges of the lower end of the case (102).

6. The electric range of any one of the preceding claims, wherein the electric wire (1141) is disposed between any one of the edges of the lower end of the case (102) and the filter circuit (116a, 116b, 116c).

7. The electric range of any one of the preceding claims, wherein the plurality of working coils (106a, 106b, 106c, 106d, 106e) include a first working coil (106a) in a central portion of the one or more base plates (108a, 108b, 108c), second and/or third working coils (106b, 106c) on a right side of the first working coil (106a), and fourth and/or fifth working coils (106d, 106e) on a left side of the first working coil (106a).

8. The electric range of any one of the preceding claims, wherein the first working coil (106a) corresponds to the high-power working coil, and the second and third working coils (106b, 106c) and/or the fourth and fifth working coils (106d, 106e) correspond to the at least one low-power working coil.

9. The electric range of any one of the preceding claims, wherein the filter circuit (116a, 116b, 116c) is disposed below any one of left and right sides of the one or more base plates (108a, 108b, 108c), and the driving circuits (110a, 110b, 110c) are disposed below the other of the left and right sides of the one or more base plates (108a, 108b, 108c) and below the central portion of the one or more base plates (108a, 108b, 108c).

10. The electric range of any one of the preceding claims, wherein the filter circuit (116a, 116b, 116c) includes a first filter circuit (116a) configured to reduce EMC-related noise generated by the first working coil (106a), a second filter circuit (116b) configured to reduce EMC-related noise generated by the second and third working coils (106b, 106c), and a third filter circuit (116c) configured to reduce EMC-related noise generated by the fourth and fifth working coils (106d, 106e).

11. The electric range of any one of the preceding claims, wherein the filter circuits (116a, 116b, 116c) are disposed in a single column at any one of the sides.

12. The electric range of claim 11, wherein
the first filter circuit (116a) is disposed in a middle of the column,
the second filter circuit (116b) is disposed on a top or bottom of the column, and
the third filter circuit (116c) is disposed on a bottom or top of the column.

13. The electric range of claims 10, 11 or 12, wherein the first filter circuit (116a) includes first and second filter cores (1161a, 1162a), the second filter circuit (116b) includes third and fourth filter cores(1161b, 1162b), and the third filter circuit (116c) includes fifth and sixth filter cores (1161c, 1162c).

14. The electric range of any one of the preceding claims, further comprising an air blowing fan (118a, 118b, 118c) configured to cool an inside of the case (102), and disposed adjacent to the filter circuit (116a, 116b, 116c), wherein air generated by the air blowing fan (118a, 118b, 118c) is supplied to the filter circuit (116a, 116b, 116c).

15. The electric range of any one of the preceding claims, further comprising:
a power feeder (114) disposed below the one or more base plates (108a, 108b, 108c) and adjacent to the filter circuit (116a, 116b, 116c) at any one of the edges of a lower end of the case (102), and configured to supply an external power;
an electric wire (1141) configured to electrically connect the power feeder (114) and the filter circuit (116a, 116b, 116c),
wherein the electric wire (1141) is disposed between the any one of edges of the case (102) and the filter circuit (116a, 116b, 116c).

## Patentansprüche

1. Elektrischer Herd, umfassend:
ein Gehäuse (102);
eine Abdeckplatte (104), die mit einem oberen Ende des Gehäuses (102) gekoppelt ist;
eine oder mehrere Basisplatten (108a, 108b, 108c), die unterhalb der Abdeckplatte (104) angeordnet sind;
eine Vielzahl von Arbeitsspulen (106a, 106b, 106c, 106d, 106e), die oberhalb der einen oder mehreren Basisplatten (108a, 108b, 108c) und unterhalb der Abdeckplatte (104) angeordnet und konfiguriert sind, um ein Objekt zu erwärmen, das auf der Abdeckplatte (104) platziert wird, um erwärmt zu werden;
eine oder mehrere Treiberschaltungen (110a, 110b, 110c), die unter der einen oder den mehreren Basisplatten (108a, 108b, 108c) angeordnet und konfiguriert sind, um die Arbeitsspulen (106a, 106b, 106c, 106d, 106e) anzutreiben; und
eine Filterschaltung (116a, 116b, 116c), die unter der einen oder den mehreren Basisplatten (108a, 108b, 108c) angeordnet und konfiguriert ist, um von den Arbeitsspulen (106a, 106b, 106c, 106d, 106e) erzeugtes Rauschen in Bezug auf elektromagnetische Verträglichkeit, EMC, zu reduzieren, **dadurch gekennzeichnet, dass**
die Arbeitsspulen (106a, 106b, 106c, 106d, 106e) eine Arbeitsspule mit hoher Leistung und mindestens eine erste Arbeitsspule mit niedriger Leistung einschließen, und
die Filterschaltung (116a, 116b, 116c) unterhalb der mindestens einen ersten Arbeitsspule mit niedriger Leistung angeordnet ist.

2. Elektrischer Herd nach Anspruch 1, wobei mindestens eine Treiberschaltung der einen oder der mehreren Treiberschaltungen (110a, 110b, 110c) unterhalb der Arbeitsspule mit hoher Leistung angeordnet ist.

3. Elektrischer Herd nach Anspruch 2, wobei die Arbeitsspulen (106a, 106b, 106c, 106d, 106e) weiter mindestens eine zweite Arbeitsspule mit niedriger Leistung einschließen, wobei mindestens eine verbleibende Treiberschaltung unter den Treiberschaltungen (110a, 110b, 110c) unterhalb der mindestens einen zweiten Arbeitsspule mit niedriger Leistung angeordnet ist.

4. Elektrischer Herd nach Anspruch 1, 2 oder 3, weiter umfassend eine Leistungszuführung (114), die unterhalb der einen oder mehreren Basisplatten (108a, 108b, 108c) und angrenzend an die Filterschaltung (116a, 116b, 116c) am unteren Ende des Gehäuses (102) angeordnet und mit einer externen Leitungsquelle verbunden ist; und einen elektrischen Draht (1141), der konfiguriert ist, um die Leistungszuführung (114) und die Filterschaltung (116a, 116b, 116c) elektrisch zu verbinden.

5. Elektrischer Herd nach einem der vorhergehenden Ansprüche, wobei die mindestens eine erste Arbeitsspule mit niedriger Leistung und die Filterschaltung (116a, 116b, 116c) angrenzend an eine der Kanten des unteren Endes des Gehäuses (102) angeordnet sind.

6. Elektrischer Herd nach einem der vorhergehenden Ansprüche, wobei der elektrische Draht (1141) zwischen einer der Kanten des unteren Endes des Gehäuses (102) und der Filterschaltung (116a, 116b, 116c) angeordnet ist.

7. Elektrischer Herd nach einem der vorhergehenden Ansprüche, wobei die Vielzahl von Arbeitsspulen (106a, 106b, 106c, 106d, 106e) eine erste Arbeitsspule (106a) in einem mittleren Abschnitt der einen oder mehreren Basisplatten (108a, 108b, 108c), zweite und/oder dritte Arbeitsspulen (106b, 106c) auf einer rechten Seite der ersten Arbeitsspule (106a) und vierte und/oder fünfte Arbeitsspulen (106d, 106e) auf einer linken Seite der ersten Arbeitsspule (106a) einschließen.

8. Elektrischer Herd nach einem der vorhergehenden Ansprüche, wobei die erste Arbeitsspule (106a) der Arbeitsspule mit hoher Leistung entspricht und die zweite und dritte Arbeitsspule (106b, 106c) und/oder die vierte und fünfte Arbeitsspule (106d, 106e) der mindestens einen Arbeitsspule mit niedriger Leistung entspricht.

9. Elektrischer Herd nach einem der vorhergehenden Ansprüche, wobei die Filterschaltung (116a, 116b, 116c) unter einer der linken und rechten Seiten der einen oder mehreren Basisplatten (108a, 108b, 108c) angeordnet ist und die Treiberschaltungen (110a, 110b, 110c) unter der anderen der linken und rechten Seiten der einen oder mehreren Basisplatten (108a, 108b, 108c) und unter dem mittleren Abschnitt der einen oder mehreren Basisplatten (108a, 108b, 108c) angeordnet sind.

10. Elektrischer Herd nach einem der vorhergehenden Ansprüche, wobei die Filterschaltung (116a, 116b, 116c) eine erste Filterschaltung (116a) einschließt, die konfiguriert ist, um EMC-bezogenes Rauschen zu reduzieren, das von der ersten Arbeitsspule (106a) erzeugt wird, eine zweite Filterschaltung (116b), die konfiguriert ist, um EMC-bezogenes Rauschen zu reduzieren, das von der zweiten und dritten Arbeitsspule (106b, 106c) erzeugt wird, und eine dritte Filterschaltung (116c), die konfiguriert ist, um EMC-bezogenes Rauschen zu reduzieren, das von der vierten und fünften Arbeitsspule (106d, 106e) erzeugt wird.

11. Elektrischer Herd nach einem der vorhergehenden Ansprüche, wobei die Filterschaltungen (116a, 116b, 116c) in einer einzigen Spalte an einer der Seiten angeordnet sind.

12. Elektrischer Herd nach Anspruch 11, wobei
die erste Filterschaltung (116a) in einer Mitte der Spalte angeordnet ist,
die zweite Filterschaltung (116b) an einer Oberseite oder Unterseite der Spalte angeordnet ist, und
die dritte Filterschaltung (116c) an einer Unterseite oder einer Oberseite der Spalte angeordnet ist.

13. Elektrischer Herd nach Anspruch 10, 11 oder 12, wobei die erste Filterschaltung (116a) einen ersten und einen zweiten Filterkern (1161a, 1162a) einschließt, die zweite Filterschaltung (116b) einen dritten und einen vierten Filterkern (1161b, 1162b) einschließt, und die dritte Filterschaltung (116c) einen fünften und einen sechsten Filterkern (1161c, 1162c) einschließt.

14. Elektrischer Herd nach einem der vorhergehenden Ansprüche, weiter umfassend ein Luftgebläse (118a, 118b, 118c), das konfiguriert ist, um ein Inneres des Gehäuses (102) zu kühlen, und das angrenzend an die Filterschaltung (116a, 116b, 116c) angeordnet ist, wobei die von dem Luftgebläse (118a, 118b, 118c) erzeugte Luft der Filterschaltung (116a, 116b, 116c) geliefert wird.

15. Elektrischer Herd nach einem der vorhergehenden Ansprüche, weiter umfassend:
eine Leistungszuführung (114), die unterhalb der einen oder mehreren Basisplatten (108a, 108b, 108c) und angrenzend an die Filterschaltung (116a, 116b, 116c) an einer der Kanten eines unteren Endes des Gehäuses (102) angeordnet ist und konfiguriert ist, um eine externe Leistung zu liefern;
einen elektrischen Draht (1141), der konfiguriert ist, um die Leistungszuführung (114) und die Filterschaltung (116a, 116b, 116c) elektrisch zu verbinden,
wobei der elektrische Draht (1141) zwischen einer der Kanten des Gehäuses (102) und der Filterschaltung (116a, 116b, 116c) angeordnet ist.

## Revendications

1. Cuisinière électrique, comportant :
un caisson (102) ;
une plaque de recouvrement (104) couplée à une extrémité supérieure du caisson (102) ;
une ou plusieurs plaques de base (108a, 108b, 108c) disposées sous la plaque de recouvrement (104) ;
une pluralité de bobines de travail (106a, 106b, 106c, 106d, 106e) disposées au-dessus de la ou des plaques de base (108a, 108b, 108c) et sous la plaque de recouvrement (104), et configurées pour chauffer un objet étant placé sur la plaque de recouvrement (104) pour être chauffé ;
un ou plusieurs circuits d'excitation (110a, 110b, 110c) disposés sous la ou les plaques de base (108a, 108b, 108c) et configurés pour exciter les bobines de travail (106a, 106b, 106c, 106d, 106e) ; et
un circuit de filtrage (116a, 116b, 116c) disposé sous la ou les plaques de base (108a, 108b, 108c) et configuré pour réduire le bruit associé à la compatibilité électromagnétique, EMC, généré par les bobines de travail (106a, 106b, 106c, 106d, 106e), **caractérisée en ce que**
les bobines de travail (106a, 106b, 106c, 106d, 106e) incluent une bobine de travail à forte puissance et au moins une première bobine de travail à faible puissance, et
le circuit de filtrage (116a, 116b, 116c) est disposé sous la au moins une bobine de travail à faible puissance.

2. Cuisinière électrique selon la revendication 1, dans laquelle au moins un circuit d'excitation parmi le ou les circuits d'excitation (110a, 110b, 110c) est disposé sous la bobine de travail à forte puissance.

3. Cuisinière électrique selon la revendication 2, dans laquelle les bobines de travail (106a, 106b, 106c, 106d, 106e) incluent en outre au moins une seconde bobine de travail à faible puissance, dans laquelle au moins un circuit d'excitation restant parmi les circuits d'excitation (110a, 110b, 110c) est disposé sous la au moins une bobine de travail à faible puissance.

4. Cuisinière électrique selon la revendication 1, 2 ou 3, comportant en outre un dispositif d'alimentation en énergie (114) disposé sous la ou les plaques de base (108a, 108b, 108c) et adjacent au circuit de filtrage (116a, 116b, 116c) sur l'extrémité inférieure du caisson (102), et relié à une source d'énergie externe ; et un fil électrique (1141) configuré pour relier électriquement le dispositif d'alimentation en énergie (114) et le circuit de filtrage (116a, 116b, 116c).

5. Cuisinière électrique selon l'une quelconque des revendications précédentes, dans laquelle la au moins une première bobine de travail à faible puissance et le circuit de filtrage (116a, 116b, 116c) sont disposés au voisinage d'un quelconque des bords de l'extrémité inférieure du caisson (102).

6. Cuisinière électrique selon l'une quelconque des revendications précédentes, dans laquelle le fil électrique (1141) est disposé entre l'un quelconque des bords de l'extrémité inférieure du caisson (102) et le circuit de filtrage (116a, 116b, 116c).

7. Cuisinière électrique selon l'une quelconque des revendications précédentes, dans laquelle les bobines de la pluralité de bobines de travail (106a, 106b, 106c, 106d, 106e) incluent une première bobine de travail (106a) dans une partie centrale de la ou des plaques de base (108a, 108b, 108c) et des deuxième et/ou troisième bobines de travail (106b, 106c) sur un côté droit de la première bobine de travail (106a), et des quatrième et/ou cinquième bobines de travail (106d, 106e) sur un côté gauche de la première bobine de travail (106a).

8. Cuisinière électrique selon l'une quelconque des revendications précédentes, dans laquelle la première bobine de travail (106a) correspond à la bobine de travail à forte puissance, et les deuxième et troisième bobines de travail (106b, 106c) et les quatrième et cinquième bobines de travail (106d, 106e) correspondent à la au moins une bobine de travail à faible puissance.

9. Cuisinière électrique selon l'une quelconque des revendications précédentes, dans laquelle le circuit de filtrage (116a, 116b, 116c) est disposé sous l'un quelconque des côtés gauche et droit de la ou des plaques de base (108a, 108b, 108c), et les circuits d'excitation (110a, 110b, 110c) sont disposés sous l'autre des côtés gauche et droit de la ou des plaques de base (108a, 108b, 108c) et sous la partie centrale de la ou des plaques de base (108a, 108b, 108c).

10. Cuisinière électrique selon l'une quelconque des revendications précédentes, dans laquelle le circuit de filtrage (116a, 116b, 116c) inclut un premier circuit de filtrage (116a) configuré pour réduire le bruit associé à l'EMC généré par la première bobine de travail (106a), un deuxième circuit de filtrage (116b) configuré pour réduire le bruit lié à l'EMC généré par les deuxième et troisième bobines de travail (116b, 116c), et un troisième circuit de filtrage (116c) configuré pour réduire le bruit lié à l'EMC généré par les quatrième et cinquième bobines de travail (106d, 106e).

11. Cuisinière électrique selon l'une quelconque des revendications précédentes, dans laquelle les circuits de filtrage (116a, 116b, 116c) sont disposés dans une seule colonne sur l'un quelconque des côtés.

12. Cuisinière électrique selon la revendication 11, dans laquelle
le premier circuit de filtrage (116a) est disposé dans un milieu de la colonne,
le deuxième circuit de filtrage (116b) est disposé sur un haut ou un bas de la colonne,
le troisième circuit de filtrage (116c) est disposé sur un bas ou un haut de la colonne,

13. Cuisinière électrique selon les revendications 10, 11 ou 12, dans laquelle le premier circuit de filtrage (116a) inclut des premier et deuxième noyaux de filtre (1161a, 1162a), le deuxième circuit de filtrage (116b) inclut des troisième et quatrième noyaux de filtre (1161b, 1162b), et le troisième circuit de filtrage (116c) inclut des cinquième et sixième noyaux de filtre (1161c, 1162c).

14. Cuisinière électrique selon l'une quelconque des revendications précédentes, comportant en outre un ventilateur de soufflage d'air (118a, 118b, 118c) configuré pour refroidir un intérieur du caisson (102), et disposé au voisinage du circuit de filtrage (116a, 116b, 116c), dans laquelle de l'air généré par le ventilateur de soufflage d'air (118a, 118b, 118c) est fourni au circuit de filtrage (116a, 116b, 116c).

15. Cuisinière électrique selon l'une quelconque des revendications précédentes, comportant en outre :
un dispositif d'alimentation en énergie (114) disposé sous la ou les plaques de base (108a, 108b, 108c) et adjacent au circuit de filtrage (116a, 116b, 116c) sur l'un quelconque des bords d'une extrémité inférieure du caisson (102), et configuré pour fournir une alimentation externe ;
un fil électrique (1141) configuré pour relier électriquement le dispositif d'alimentation en énergie (114) et le circuit de filtrage (116a, 116b, 116c),
dans laquelle le fil électrique (1141) est disposé entre l'un quelconque des bords du caisson (102) et le circuit de filtrage (116a, 116b, 116c).
